(19) Europäisches Patentamt
European Patent Office
Office européen des brevets

(11) Publication number: **0 211 406**
**A2**

(12) # EUROPEAN PATENT APPLICATION

(21) Application number: 86110605.2

(51) Int. Cl.[4]: **G03C 1/68**

(22) Date of filing: 31.07.86

(30) Priority: 02.08.85 US 762080
02.08.85 US 762090
02.08.85 US 762091
02.08.85 US 762088
02.08.85 US 762010

(43) Date of publication of application:
25.02.87 Bulletin 87/09

(84) Designated Contracting States:
DE FR GB

(71) Applicant: AMERICAN HOECHST CORPORATION
Route 202-206 North
Somerville, N.J. 08876(US)

(72) Inventor: Walls, John E., Dipl.-Chem.
19 Bowlby Street
Hampton New Jersey 08801(US)
Inventor: Dhillon, Major S., Dipl.-Chem.
896C Merrit Drive
Hillsborough New Jersey 08876(US)
Inventor: Pagano, Frank C., Dipl.-Chem.
460 Hyatt Street
Avenel New Jersey 07001(US)
Inventor: Tellechea, Carlos, Dipl.-Chem.
82 East End Avenue
Shrewsbury New Jersey 07701(US)

(74) Representative: Neubauer, Hans-Joachim
KALLE Niederlassung der Hoechst AG
Patentabteilung Postfach 3540
Rheingaustrasse 190
D-6200 Wiesbaden1(DE)

(54) **Photopolymerizable composition with polyvinyl acetal as a binder, and registration material prepared thereof.**

(57) Es wird ein photopolymerisierbares Gemisch beschrieben, das einen Photoinitiator, ein polymerisierbares Acryl-oder Methacrylsäurederivat mit einer oder mehreren ungesättigten Gruppen und ein polymeres Bindemittel aus 5 bis 20 Gew.-% Vinylacetat-, 4 bis 30 Gew.-% Vinylalkohol-und 50 bis 91 Gew.-% Vinylacetaleinheiten enthält, wobei die Vinylacetaleinheiten C aus Einheiten der Formel C I, C II und C III

EP 0 211 406 A2

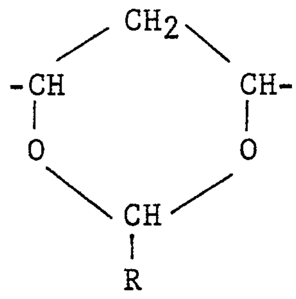

(C I),

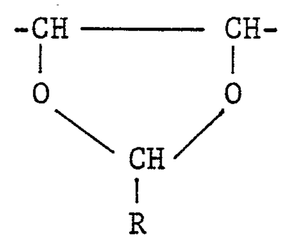

(C II),

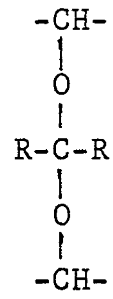

(C III)

bestehen, worin R ein Wasserstoffatom oder eine niedere Alkylgruppe ist.

Das Gemisch ergibt Schichten, die sich mit rein wäßrigen Lösungen entwickeln lassen und hohe Druckauflagen im Flachdruck ergeben. Es kann ferner zur Herstellung von mechanisch sehr resistenten Siebdruckschablonen verwendet werden, die durch Entwickeln mit reinem Wasser herstellbar sind.

# Photopolymerisierbares Gemisch mit Polyvinylacetal als Bindemittel und daraus hergestelltes Aufzeichnungsmaterial

Die vorliegende Erfindung betrifft ein photopolymerisierbares Gemisch, das zur Herstellung von mit wäßrigen Entwicklern entwickelbaren Reproduktionsmaterialien, wie Flachdruckplatten oder Siebdruckschablonen, geeignet ist. Das Gemisch läßt sich leicht zu Schichten mit guten Hafteigenschaften verarbeiten, die insbesondere für die Herstellung von Flachdruckplatten geeignet sind.

Es sind zahlreiche Polymere bekannt, die allgemein für die Herstellung von lichtempfindlichen Materialien geeignet sind. Die Einsatzmöglichkeiten der meisten dieser Harze sind jedoch eingeschränkt, da zum Entwickeln der mit ihnen hergestellten lichtempfindlichen Materialien beträchtliche Mengen organischer Lösemittel benötigt werden. Derartige Entwickler sind jedoch unerwünscht, da ihre Abwässer und Dämpfe toxisch und umweltschädlich und die Lösemittel teuer sind.

Mischpolymere aus Vinylacetat, Vinylacetal und Vinylalkohol, im allgemeinen als Polyvinylacetale bezeichnet, sind aus der US-A 2 179 051 bekannt. Bei Verwendung dieser Harze zur Herstellung von lichtempfindlichen Materialien werden zum Entwickeln Entwickler mit einem Gehalt an organischen Lösemitteln benötigt.

Es ist Aufgabe der vorliegenden Erfindung, ein photopolymerisierbares Gemisch vorzuschlagen, das zur Herstellung eines photopolymerisierbaren Materials geeignet ist, für dessen Entwicklung eine Lösung verwendet werden kann, die keine organischen Lösemittel und nur geringe Mengen an Salzen und Netzmitteln enthält.

Das Bindemittel des Gemischs sollte eine gute Entwicklerlöslichkeit der lichtempfindlichen Schicht gewährleisten, wobei eine Wiederablagerung von dispergierten Schichtteilen auf der Oberfläche des Materials ausgeschlossen wird. Das Harz sollte ferner die Herstellung eines photopolymerisierbaren Materials ermöglichen, das sich durch hohe Lichtempfindlichkeit, Bildauflösung und Druckauflage auszeichnet und das außerdem mit den übrigen Lösungen verträglich ist, die normalerweise bei der Herstellung und bei der Verarbeitung von Druckplatten verwendet werden.

Gegenstand der Erfindung ist ein photopolymerisierbares Gemisch, das als wesentliche Bestandteile einen Photoinitiator, ein polymerisierbares Acryl-oder Methacrylsäurederivat mit einer oder mehreren ungesättigten Gruppen und ein polymeres Bindemittel aus Einheiten der allgemeinen Typen A, B und C enthält, wobei A in einem Mengenanteil von 5 bis 20 Gew.-% vorliegt und der Formel

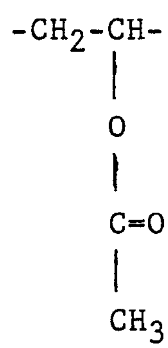

entspricht, B in einem Mengenanteil von 4 bis 30 Gew.-% vorliegt und der Formel

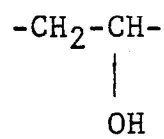

entspricht und C in einem Mengenanteil von 50 bis 91 Gew.-% vorliegt.

Das erfindungsgemäße Gemisch ist dadurch gekennzeichnet, daß die Einheiten C aus Einheiten der Formel C I, C II und C III

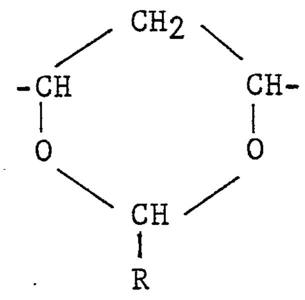

(C I),

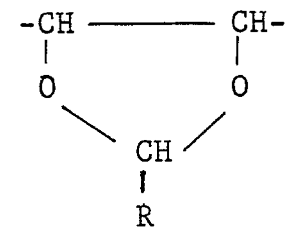

(C II),

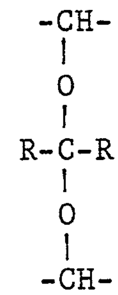

(C III)

bestehen, worin

R ein Wasserstoffatom oder eine niedere Alkylgruppe ist

und worin die Einheiten C I in einem Anteil von 75 bis 85 Gew.-%, die Einheiten C II in einem Anteil von 3 bis 5 Gew.-% und die Einheiten C III in einem Anteil von 10 bis 22 Gew.-%, bezogen auf das Gesamtgewicht der Einheiten C, vorliegen.

Die in dem photopolymerisierbaren Gemisch enthaltenen polymeren Bindemittel sind neue Verbindungen. Sie werden in der gleichzeitig eingereichten Patentanmeldung ........... (Hoe 85/K109K) ausführlich beschrieben. Ihre Herstellung erfolgt, indem man

a) ein Vinylalkohol/Vinylacetat-Copolymeres mit einem Gehalt von 75 bis 80 Gew.-% Vinylalkoholeinheiten in einem Gemisch von Wasser und einem Hydroxylgruppen enthaltenden organischen Lösemittel auflöst,

b) die Lösung auf eine Temperatur zwischen 50°C und ihrem Siedepunkt erwärmt und eine katalytische Menge einer organischen Sulfonsäure oder einer Mineralsäure zusetzt und

c) einen niederen aliphatischen Aldehyd in solcher Menge zusetzt, daß 50 bis 91 Gew.-% der Hydroxylgruppen acetalisiert werden.

Gegenstand der Erfindung ist außerdem ein photopolymerisierbares Aufzeichnungsmaterial mit einem Schichtträger und einer photopolymerisierbaren Schicht, die aus dem vorstehend definierten Gemisch besteht.

Im Rahmen der vorliegenden Erfindung bezeichnet der Ausdruck "niedere Alkylgruppe" einen gesättigten gerad-oder verzweigtkettigen Kohlenwasserstoffrest mit 1 bis 8 Kohlenstoffatomen.

Die Vinylalkohol/Vinylacetatcopolymeren, die bei der Herstellung der polymeren Bindemittel als Ausgangsmaterial geeignet sind, sind zu 75 bis 80 Gew.-% hydrolysiert und haben ein durchschnittliches Molekulargewicht ($\bar{M}$) von 5.000 bis 100.000. In dieser Beschreibung wird der hydrolysierte Anteil in Gewichtsprozent und nicht in Molprozent angegeben. Geeignete Copolymere können mittels bekannter Syntheseverfahren leicht hergestellt werden, bzw. sind im Handel erhältlich. Dazu gehören beispielsweise Vinol 523 ( $\bar{M}$ = 70.000) und Vinol 205 ( $\bar{M}$ = 26.000), Hersteller Air Products Co., Allentown, Pennsylvania; Elvanol 52-22 ( $\bar{M}$ = 72.000) Hersteller Du Pont, Wilmington, Delaware; und Gelvatol 20-60 ( $\bar{M}$ = 60.000) und Gelvatol 20-90 ( $\bar{M}$ = 90.000) Hersteller Monsanto Co., St. Louis, Missouri.

Die Auswahl des als Ausgangsmaterial jeweils eingesetzten Copolymeren hängt von der späteren Verwendung des daraus hergestellten Polymeren ab. Wenn das Polymere beispielsweise zur Herstellung von Flachdruckplatten dient, werden bevorzugt Copolymere mit höheren Molekulargewichten (etwa 50.000 bis 100.000) gewählt. Soll das Polymere bei der Herstellung von Siebdruckschablonen verwendet werden, werden bevorzugt Copolymere mit niedrigeren Molekulargewichten (etwa 5.000 bis 30.000) eingesetzt. Diese bevorzugten Bereiche müssen jedoch nicht zwingend eingehalten werden.

Zur Herstellung des Acetalgruppen enthaltenden Polymeren wird das Copolymere zunächst in einem Gemisch aus Wasser und einem hydroxylgruppenhaltigen Lösemittel gelöst. Das hydroxylgruppenhaltige Lösemittel muß mit Wasser mischbar und sowohl für das Copolymere als auch für das als Endprodukt erhaltene Polymere als Lösemittel geeignet sein. Bevorzugt ist das hydroxylgruppenhaltige Lösemittel ein aliphatischer Alkohol, der insbesondere 1 bis 4 C-Atome besitzt, z. B. Ethanol.

In einem ersten Verfahrensschritt wird durch Lösen des Vinylalkohol/ Vinylacetat-Copolymeren in einem Lösemittelgemisch aus Wasser und einem hydroxylgruppenhaltigen Lösemittel eine Reaktionslösung hergestellt. Dieser Schritt wird üblicherweise über eine Zeitdauer von mindestens 12 Stunden durchgeführt bei einer Temperatur, die je nach dem Molekulargewicht des Copolymeren zwischen 20° C und dem Siedepunkt der Lösung liegt. Anschließend wird die Temperatur der Lösung auf mindestens 50° C eingestellt, und es wird eine katalytisch wirkende Menge, bevorzugt etwa 1,0 bis 1,5 Gew.-%, einer Säure zugegeben. Diese Menge reicht nicht zur Hydrolyse aus. Innerhalb eines Zeitraums von mehreren Stunden wird dem mit der Säure versetzten Gemisch langsam ein aliphatischer Aldehyd beigemischt. Die Menge des Aldehyds wird so gewählt, daß der Acetalisierungsgrad zwischen 50 und 91 Gew.-% liegt. Das Reaktionsgemisch wird bevorzugt während aller vorstehend beschriebener Verfahrensstufen kräftig gerührt. Vorzugsweise wird die Säure anschließend verdampft oder das Gemisch neutral gestellt.

Als Aldehyd wird Acetaldehyd oder Propionaldehyd bevorzugt. Die Wahl des jeweiligen Aldehyds hängt auch vom Verwendungszweck des erfindungsgemäßen Harzes ab. Für die Herstellung von Flachdruckplatten wird Propionaldehyd bevorzugt, während für die Herstellung einer Siebdruckschablone Acetaldehyd bevorzugt wird. Die Menge des zugesetzten Aldehyds beträgt vorzugsweise 25 bis 100 Gew.-%, insbesondere 28 bis 67 Gew.-%, jeweils bezogen auf das Gewicht des Copolymeren.

Da die Bildung der Acetalgruppen auf Kosten des Hydroxylgruppengehalts des Copolymeren erfolgt, nimmt die Wasserlöslichkeit ab. Um eine vorzeitige Ausfällung des Reaktionsproduktes zu verhindern, wird zusammen mit dem Aldehyd eine zusätzliche Menge des in dem Lösemittelgemisch enthaltenen hydroxylgruppenhaltigen Lösemittels zudosiert und so die abnehmende Wasserlöslichkeit und zunehmende Lösemittellöslichkeit des Produktes ausgeglichen.

Für die Bildung der Acetalgruppen muß während der Aldehydzugabe eine katalytische Menge einer Säure anwesend sein. Dabei handelt es sich bevorzugt um eine Mineralsäure, z. B. Salzsäure, Schwefelsäure oder Phosphorsäure, oder um eine organische Sulfonsäure, z. B. p-Toluolsulfonsäure oder Stilbendisulfonsäure. Salzsäure wird besonders bevorzugt.

Nach Beendigung der Zugabe wird das Reaktionsgemisch bevorzugt neutral gestellt; dies geschieht durch Zugabe eines alkalischen Salzes, wodurch eine mögliche Deacetalisierung vermieden wird. Durch die Neutralisation wird der pH-Wert des Reaktionsgemischs auf 6,5 bis 7,5, bevorzugt auf 7,0 eingestellt. Geeignete alkalische Salze sind beispielsweise Natrium-und Kaliumcarbonat, wobei Natriumcarbonat besonders bevorzugt wird. Auch Natrium-und Kaliumhydroxid sind geeignet.

Im Anschluß an die Neutralisation wird das Reaktionsgemisch bevorzugt, jedoch nicht zwingend, auf Raumtemperatur (22-25° C) abgekühlt und danach langsam mit Wasser oder einem anderen geeigneten Mittel, wie Aceton oder Methylethylketon, versetzt. Dabei wird das Gemisch weiterhin stark gerührt, um die Ausfällung des Reaktionsproduktes zu bewirken. Das ausgefällte Produkt wird mit Wasser gewaschen, um die Reste an Säure, Aldehyd und nicht umgesetztem Copolymeren zu entfernen, und wird anschließend mit Warmluft getrocknet, bis der Wasseranteil maximal 1 % beträgt.

Für die Herstellung des Beschichtungsgemmischs wird gewöhnlich ein Lösemittel eingesetzt, das mit allen Bestandteilen des lichtempfindlichen Gemisches verträglich ist. Als Beispiele für geeignete Lösemittel seien Wasser, Tetrahydrofuran, Butyrolacton, Glykolether, wie Propylenglykolmonomethylether und Ethylenglykolmonomethylether, Alkohole, wie Ethanol und n-Propanol, und Ketone, wie Methylethylketon, sowie Mischungen der aufgeführten Lösemittel genannt. Bevorzugt wird als Lösemittel ein Gemisch aus Tetrahydrofuran, Propylenglykolmonomethylether und Butyrolacton verwendet. Das fertige Gemisch wird auf den Schichtträger aufgetragen, und das Lösemittel wird verdampft.

Der Anteil des polymeren Bindemittels am lichtempfindlichen Gemisch beträgt vorzugsweise 20 bis 75 Gew.-%, insbesondere 30 bis 65 Gew.-%, und ganz besonders bevorzugt 35 bis 50 Gew.-%, jeweils bezogen auf den Feststoffgehalt des Gemischs.

Als Photoinitiatoren eignen sich erfindungsgemäß bevorzugt radikalische Photoinitiatoren mit einem Absorptionsbereich von 320 bis 400 nm, z. B. Acetophenone, Benzophenone, Triazine, Benzoine, Benzoinether, Xanthone, Thioxanthone, Acridine und Benzochinone, wobei die 2-Aryl-4,6-bistrichlormethyl-triazine und die Thioxanthone besonders bevorzugt werden.

Der Anteil des Photoinitiators am lichtempfindlichen Gemisch beträgt bevorzugt 1,5 bis über 8 Gew.-%, insbesondere 2,0 bis 6,0 Gew.-%, und ganz besonders bevorzugt 3,0 bis 4,0 Gew.-%, jeweils bezogen auf den Feststoffgehalt des Gemischs.

Der polymerisierbare Bestandteil des erfindungsgemäßen Gemischs ist ein Acryl-oder Methacrylsäurederivat mit einer oder mehreren ungesättigten Gruppen, bevorzugt ein Acryl-oder

Methacrylsäureester. Er kann in fester oder flüssiger Form vorliegen und hat vorzugsweise eine Viskosität von mehr als 700 mPa•s bei 25° C, insbesondere von mehr als 2000 mPa•s bei 25° C und besonders bevorzugt von mehr als 4000 mPa•s bei 25° C.

Zu den Verbindungen, die als Monomere geeignet sind, zählen beispielsweise Trimethylolpropantriacrylat und -methacrylat und deren ethoxylierte oder propoxylierte Derivate, Pentaerythrittriacrylat und -methacrylat, Dipentaerythritmonohydroxypentaacrylat und -methacrylat, Dipentaerythrithexaacrylat und -methacrylat, Pentaerythrittetraacrylat und -methacrylat, Pentaerythritmethacrylat, Tetrahydrofurfurylacrylat und -methacrylat, Cyclohexylacrylat und -methacrylat, n-Hexylacrylat und -methacrylat, Glycidylacrylat und -methacrylat. Bevorzugt wird Dipentaerythritmonohydroxypentaacrylat eingesetzt, doch kann auch eine Kombination verschiedener geeigneter Monomerer mit Vorteil eingesetzt werden.

Der Anteil des Monomeren beträgt bevorzugt 20 bis 70 Gew.-%, insbesondere 30 bis 60 Gew.-%, und ganz besonders bevorzugt 30 bis 50 Gew.-%, jeweils bezogen auf den Feststoffgehalt des erfindungsgemäßen Gemischs.

In besonderer Ausführungsform enthält das erfindungsgemäße Gemisch ein polyfunktionelles Acrylmonomeres mit zwei oder mehr ungesättigten Gruppen und ein Urethangruppen enthaltendes Oligomeres.

Bei der oligomeren Komponente des erfindungsgemäßen photopolymerisierbaren Gemischs handelt es sich um ein lichthärtbares Oligomeres bzw. Polymeres, das erhalten wird, indem man zunächst ein mol einer im wesentlichen linearen polymeren Verbindung, die an jedem Ende ein aktives Wasserstoffatom trägt, mit mindestens zwei mol einer Diisocyanatverbindung umsetzt, so daß ein Präpolymeres entsteht, das an beiden Enden einen Isocyanatrest trägt. Anschließend wird das Präpolymere mit mindestens zwei mol einer ethylenisch ungesättigten Verbindung mit einem aktiven Wasserstoffatom umgesetzt, so daß das Präpolymere an beiden Enden einen ungesättigten Rest erhält. Bevorzugt besitzt das Oligomere ein Polyestergerüst aus einer aliphatischen Dicarbonsäure und einem aliphatischen Diol. Bevorzugt wird eine lineare Dicarbonsäure mit 2 bis 8 Kohlenstoffatomen verwendet. Als Polyester wird eine symmetrische Verbindung mit endständigen Hydroxygruppen verwendet. Herstellungsverfahren für Verbindungen dieses Typs sind bekannt und beispiels weise von Sandler und Karo in "Polymer Synthesis", Bd. 2, Academic Press, 1977, S.140-167, beschrieben. Das Polyesterpolyol wird sodann bevorzugt mit einem aliphatischen Diisocyanat mit 2 bis 15 C-Atomen, insbesondere mit einem cycloaliphatischen Diisocyanat, umgesetzt, und zwar derart, daß eine der beiden Isocyanatgruppen mit der endständigen Hydroxygruppe des Polyestergerüsts reagiert. Die andere Isocyanatgruppe wird anschließend mit einem Hydroxygruppen enthaltenden Acryl-oder Methacrylsäureester umgesetzt. Beispielsweise wird 1,6-Hexandiol mit Adipinsäure zu einem Polyester umgesetzt, wobei das Molverhältnis größer als 1:1 ist, und der Polyester anschließend mit Dicyclohexylmethan-4,4'-bis-diisocyanat zur Reaktion gebracht, wobei das Molverhältnis von Diisocyanat zu Polyester 2:1 beträgt. Das erhaltene Produkt wird mit 2-Hydroxyethylacrylat zu einem ungesättigten Oligomeren umgesetzt, wobei das Molverhältnis von Acrylat zu dem Diisocyanat-Polyester-Reaktionsprodukt 2:1 beträgt.

Das Oligomere kann anhand der folgenden Formel dargestellt werden:

U-D-R'-D-U,

in der

R' der Rest einer im wesentlichen linearen polymeren Verbindung ist, die 2 Endgruppen mit einem aktiven Wasserstoffatom besitzt,

D der Rest einer Diisocyanatverbindung ist und

U der Rest einer ethylenisch ungesättigten Verbindung mit einem aktiven Wasserstoff ist.

Verbindungen, die als R'-Gruppen geeignet sind, sind z.B. Polyester mit endständigen Hydroxylgruppen; Polyether, die durch Umsetzung eines Diols mit einem Alkylenoxid erhalten werden, wobei das Molverhältnis von Diol zu Alkylenoxid größer als 1:1 sein muß, damit ein symmetrisches Polymeres mit endständigen Hydroxylgruppen erhalten wird; und Epoxide, die durch Umsetzung einer symmetrischen Diglycidylverbindung mit einem Diol erhalten werden, wobei das Molverhältnis von Diol zu Diglycidylverbindung größer als 1:1 sein muß, damit ein symmetrisches Polymeres mit endständigen Hydroxylgruppen erhalten wird.

Geeignete Polyester werden zum Beispiel aus den Dicarbonsäuren Oxal-, Malon-, Bernstein-, Glutar-, Adipin-, Pimelin-, Kork-, Azelain-oder Sebacinsäure und den Diolen Ethylen-, Diethylen-, Neopentyl-, Propylen-und Dipropylenglykol, 1,3-Butandiol, 1,4-Butandiol, 1,6-Hexandiol oder 2-Ethyl-1,6-hexandiol hergestellt.

Geeignete Polyether werden zum Beispiel aus den obengenannten Diolen und Ethylenoxid, Propylenoxid oder Tetrahydrofuran hergestellt.

Geeignete Epoxide werden zum Beispiel aus den obengenannten Diolen und Diglycidylisophthalat, Diglycidylterephthalat, Diglycidylphthalat oder Bisphenol-A-diglycidylether hergestellt.

Geeignete Diisocyanate sind z. B. Ethylendiisocyanat, Propylendiisocyanat, Tetramethylendiisocyanat, Dicyclohexylmethan-4,4'-diisocyanat, Hexamethylendiisocyanat, 1-Methyl-2,3-diisocyanato-cyclohexan, 1-Methyl-2,6-diisocyanato-cyclohexan, Lysindiisocyanat, 4,4'-Ethylen-bis-(cyclohexylisocyanat) und Isophorondiisocyanat.

Geeignete ethylenisch ungesättigte Verbindungen mit aktiven Wasserstoffatomen sind z. B. Hydroxyethylacrylat und -methacrylat, Hydroxypropylacrylat und -methacrylat, 1,3-Butandiolacrylat und -methacrylat, 2,4-Butandiolacrylat, 1,4-Butandiolmethacrylat, Neopentylglycolacrylat und -methacrylat, Pentaerythrittriacrylat und -trimethacrylat, sowie die Monoacrylate und Monomethacrylate von Polyethylenglykol, Polypropylenglykol und von Copolymeren von Ethylenglykol und Propylenglykol.

Im Rahmen der vorliegenden Erfindung werden bevorzugt die Oligomeren mit einem Molekulargewicht von etwa 1500 bis 4000, insbesondere von etwa 2000 bis 3500, eingesetzt. Ganz besonders bevorzugt werden Oligomere verwendet, deren Molekulargewicht etwa 3000 beträgt. Vorteilhafterweise liegt das Oligomere in fester oder halbfester Form vor, d.h., seine Viskosität bei 25° C ist größer als etwa 480 Pa•s. Der bevorzugte Anteil des Gemischs an Oligomerem beträgt etwa 10 bis 35 Gew.-%, insbesondere etwa 15 bis 30 Gew.-%, und ganz besonders bevorzugt etwa 15 bis 25 Gew.-%, jeweils bezogen auf den Gesamtfeststoffgehalt. Eine detaillierte Beschreibung solcher Oligomerer ist in der EP-A 184 725 enthalten.

Gemäß einer anderen Ausführungsform der Erfindung besteht die polymerisierbare Komponente aus einem Gemisch aus einem Polyglykoldiacrylat, z. B. einem Diacrylat eines polyethoxylierten Diols, und einem Aminodiacrylat. Außerdem enthält das Gemisch bevorzugt noch ein polyfunktionelles Acrylatmonomeres und ein oligomeres Urethanacrylat.

Als erfindungsgemäß geeignetes polyethoxyliertes Diacrylat wird bevorzugt eine Verbindung der Formel

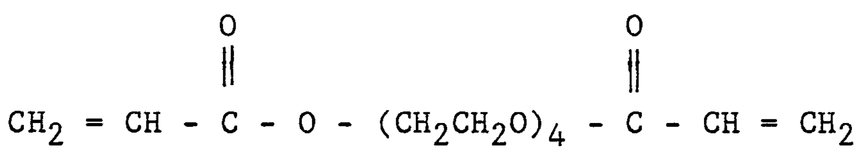

eingesetzt (Polyethylenglykol-200-Diacrylat, im Handel als Photomer 4050). Dieses Diacrylat ist im erfindungsgemäßen Gemisch vorzugsweise in einer Menge von 14 bis 24 Gew.-%, insbesondere von 16 bis 23 Gew.-%, und ganz besonders bevorzugt von 18 bis 21 Gew.-% enthalten.

Als Aminodiacrylat wird im erfindungsgemäßen Gemisch bevorzugt eine Triaminoverbindung eingesetzt, die z. B. der allgemeinen Formel

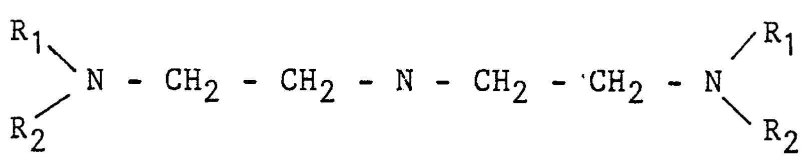

entspricht, in der

$R_1$ $CH_2=CH-\overset{O}{\overset{\|}{C}}-O-(CH_2)_n-$bedeutet, wobei n eine Zahl von 0 bis 4 ist, und

$R_2$ ein Wasserstoffatom, eine Hydroxylgruppe oder die Gruppe $-(CH_2)_mOH$ bedeutet, wobei m eine Zahl von 1 bis 4 ist.

Diese Verbindung kann nach bekannten Verfahren hergestellt werden und ist im Handel unter der Bezeichnung Celrad 7100 erhältlich (Herst. Celanese Specialty Resins, Louisville, Kentucky). Das Aminodiacrylat ist in dem erfindungsgemäßen Gemisch bevorzugt in einer Menge von 11,5 bis 24 Gew.-%, insbesondere von 16 bis 23 Gew.-%, und ganz besonders bevorzugt von 18 bis 21 Gew.-%

enthalten. Vorzugsweise beträgt das Gewichtsverhältnis von Polyglykoldiacrylat zu Aminodiacrylat im erfindungsgemäßen Gemisch etwa 1:1.

Zu den besonderen Merkmalen der vorliegenden Erfindung zählt, daß das oligomere Aminodiacrylat in dem Photopolymergemisch sowohl als Oligomeres als auch als Aktivator für den Photoinitiator dient, da es wegen seines relativ hohen Anteils an tertiären Stickstoffatomen ein Wasserstoffdonator ist.

Durch die Kombination von mehrfach ungesättigtem Acrylsäurederivat und Aminoacrylat in dem erfindungsgemäßen Gemisch erhalten die mit dem Gemisch hergestellten Siebdruckschablonen erhöhte mechanische Stabilität und Abriebfestigkeit.

Das multifunktionelle Acrylmonomere hat bevorzugt zwei oder mehrere ungesättigte Reste, wie Trimethylolpropantriacrylat. Insbesondere ist das mehrwertige Acrylatmonomere noch ethoxyliert, wie Trimethylolpropanpolyethylenoxytriacrylat, das unter der Bezeichnung Photomer 4149 (Herst. Diamond Shamrock Corporation) oder SR-454 (Herst. Sartomer Company) im Handel erhältlich ist. Weitere erfindungsgemäß geeignete polyfunktionelle Acrylatmonomere sind z. B. ein hexafunktionelles Polyesteracrylat, das unter der Bezeichnung Photomer 5007 (Herst. Diamond Shamrock Corporation) im Handel erhältlich ist, ein tetrafunktionelles Polyesteracrylat, das unter der Bezeichnung Photomer 5018 (Herst. Diamond Shamrock Corporation) im Handel erhältlich ist, Pentaerythrittriacrylat, Pentaerythrittetraacrylat und Dipentaerythritmonohydroxypentaacrylat. Das polyfunktionelle Acrylatmonomere ist in dem Gemisch gegebenenfalls in einer Menge bis zu 18 Gew.-%, bevorzugt von 9 bis 16 Gew.-%, und insbesondere von 10 bis 14 Gew.-% enthalten.

Das oligomere Urethanacrylat, das ferner im beschriebenen Photopolymergemisch enthalten sein kann, entspricht vorzugsweise der allgemeinen Formel

$$R_3 - O - \overset{O}{\overset{\|}{C}} - NH - R_4 - NH - \overset{O}{\overset{\|}{C}} - O - R_5 - O - R_6$$

in der

$R_3$ und $R_6$ gleich sind und $-\overset{O}{\overset{\|}{C}}-CH=CH_2$ bedeuten und

$R_4$ und $R_5$ gleich sind und $-C_6H_3R_7$ bedeuten,

wobei $R_7$ = $-CH_3$ oder $-H$ ist.

Verbindungen dieser Art sind unter der Bezeichnung Purelast 155A (Herst. Polymer Systems Corporation, East Brunswick, New Jersey) im Handel erhältlich. Das oligomere Urethanacrylat ist in dem Gemisch gegebenenfalls in einer Menge bis zu 18 Gew.-%, bevorzugt in einer Menge von 9 bis 16 Gew.-%, und insbesondere von 10 bis 14 Gew.-% enthalten. Das polyfunktionelle Acrylmonomere und das oligomere Urethanacrylat sind, soweit vorhanden, in dem Photopolymergemisch vorzugsweise etwa im Verhältnis 1:1 enthalten.

Zu den hervorragenden Merkmalen dieser Ausführungsform der Erfindung zählt, daß es aufgrund der neuen Kombination von Photoinitiator, Aminodiacrylat und übrigen Monomeren nicht mehr unbedingt erforderlich ist, eine Sauerstoffsperrschicht aufzubringen oder in einer Stickstoffschutzgasatmosphäre zu arbeiten.

Das erfindungsgemäße Gemisch ist besonders für die Herstellung von Siebdruckschablonen geeignet. Dabei beträgt das Verhältnis von harzartigem Bindemittel zu Monomerengemisch vorzugsweise etwa 1:2.

Der Anteil des harzartigen Bindemittels am erfindungsgemäßen Siebdruckgemisch beträgt bevorzugt 28 bis 38 Gew.-%, insbesondere 30 bis 36 Gew.-%, und ganz besonders bevorzugt 32 bis 34 Gew.-%.

Bei dieser Ausführungsform der Erfindung wird als Photoinitiator vorzugsweise eine Thioxanthonverbindung, insbesondere 2-Isopropyl-9H-thioxanthen-9-on, eingesetzt. Der Anteil des Photoinitiators am Siebdruckgemisch beträgt bevorzugt 0,1 bis 1,0 Gew.-%, insbesondere 0,2 bis 0,8 Gew.-%, und ganz besonders bevorzugt 0,2 bis 0,4 Gew.-%.

Zur Herstellung des erfindungsgemäßen Siebdruckgemischs werden das Monomerengemisch und der Photoinitiator zunächst in einem geeigneten Lösemittel gelöst, so daß eine Lösung erhalten wird, deren Feststoffgehalt vorzugsweise 55 bis 56 % beträgt. Geeignete Lösemittel sind beispielsweise Alkohole mit 1 bis 4 C-Atomen, γ-Butyrolacton, N-Methylpyrrolidon und Gemische dieser Lösemittel untereinander oder mit Wasser. Ethanol wird als Lösemittel bevorzugt. Die Lösung aus

polymerisierbaren Verbindungen und Photoinitiator wird sodann mit der Lösung des harzartigen Bindemittels zu einer klaren, viskosen Lösung vereinigt.

Die Tatsache, daß das erfindungsgemäße Gemisch in der beschriebenen Ausführungsform als Lösung vorliegt, stellt einen weiteren Vorteil der Erfindung dar, da Lösungen eine bessere Lagerfähigkeit besitzen als die üblicherweise verwendeten Emulsionen und vom Anwender vor Gebrauch nicht nochmals homogenisiert werden müssen.

Zus Herstellung einer Siebdruckschablone mit dem erfindungsgemäßen Gemisch wird ein Gewebe der gewünschten Fadendicke, Maschenzahl und Zusammensetzung zunächst gestreckt, bis die gewünschte Spannung erreicht ist. Die Streckung erfolgt bevorzugt auf mechanischem Weg über einem geeigneten Rahmen. Geeignete Materialien für die Gewebe sind Polyester, Polyamid und Edelstahl, die Rahmen können aus Holz oder Metall, insbesondere Aluminium, sein. Das gespannte Gewebe wird am Rahmen befestigt; dies kann mit Klebstoffen (bei Holz-oder Metallrahmen), mit Heftklammern (bei Holzrahmen) oder mechanisch (bei selbstspannenden Rahmen) erfolgen. Das solchermaßen vorbereitete Sieb wird entfettet, um alle Schmutz-, Staub-, Fett-und Ölreste zu entfernen, die die Haftung des Beschichtungsgemischs an den Maschen beeinträchtigen könnten.

Anschließend wird das Sieb mit dem erfindungsgemäßen Gemisch beschichtet; dafür sind eine Reihe bekannter Verfahren geeignet. Beispielsweise kann das Gemisch mit Hilfe einer Rakel in mehreren Arbeitsgängen direkt auf beide Seiten des Siebs aufgetragen und anschließend getrocknet werden; es kann aber auch zunächst auf eine Übertragungsfolie aufgebracht und getrocknet werden und dann entweder vor oder nach dem Belichten und Entwickeln in Form eines Films auf das Sieb übertragen werden; auch eine Kombination dieser beiden Verfahren ist möglich.

In einer weiteren speziellen Ausführungsform enthält das erfindungsgemäße photopolymerisierbare Gemisch ein polyfunktionelles Acrylmonomeres mit mindestens zwei ungesättigten Resten und ein monofunktionelles Acrylmonomeres mit einem ungesättigten Rest.

Das polyfunktionelle Acrylmonomere wurde vorstehend bereits beschrieben.

Das monofunktionelle Monomere ist bevorzugt eine Verbindung mit einer Acryl-oder Methacrylsäureestergruppe. Es liegt bevorzugt in Form einer Flüssigkeit vor, deren Viskosität bei 25° C zwischen 1 und 25 mPa•s beträgt.

Zu den erfindungsgemäß geeigneten monofunktionellen Monomeren zählen beispielsweise Trimethylolpropanmonoacrylat und -methacrylat und deren ethoxylierte oder propoxylierte Derivate, Pentaerythritacrylat und -methacrylat, Tetrahydrofurfurylacrylat und -methacrylat, Cyclohexylacrylat und -methacrylat, n-Hexylacrylat und -methacrylat, sowie Glycidylacrylat und -methacrylat. Bevorzugt wird Pentaerythritacrylat verwendet, doch hat sich auch eine Kombination verschiedener Monomerer als vorteilhaft erwiesen.

Im photopolymerisierbaren Gemisch aus diesen beiden Monomeren sollte der Anteil des polyfunktionellen Monomeren mindestens 50 %, bevorzugt 65 bis 99 % und insbesondere 80 bis 97,5 % betragen. Den Rest des photopolymerisierbaren Gemischs bildet dann das monofunktionelle Monomere.

Einer der besonderen Vorteile dieser Ausführungsform der Erfindung besteht darin, daß durch die dreidimensional vernetzte Struktur der Polymerisationsprodukte des polyfunktionellen Monomeren eine gute Festigkeit der Bildstellen und somit ein zähes Bild erzielt wird, während durch die lineare Polymerisation des monofunktionellen Monomeren eine hohe Lichtempfindlichkeit erreicht wird.

Auch bei dieser Ausführungsform ist das Aufbringen einer Sauerstoffsperrschicht bzw. das Arbeiten in einer Stickstoffschutzgasatmosphäre nicht erforderlich.

Zu den entscheidenden Vorteilen, die die vorliegende Erfindung mit sich bringt, zählt, daß die erfindungsgemäßen lichtempfindlichen Gemische mit einem Entwickler entwickelt werden können, in dem organische Lösemittel nicht zwingend vorhanden sein müssen, und der lediglich einen geringen Anteil an Salzen und Netzmitteln benötigt. Der Einsatz organischer Lösemittel stellt einen erheblichen Kostenfaktor dar. Überdies sind die Abwässer mit diesen Lösemitteln giftig und gesundheitsschädlich.

Außerdem kann das erfindungsgemäße lichtempfindliche Gemisch noch andere Bestandteile, z. B. stabilisierende Säuren, Belichtungsindikatoren, Weichmacher, Photoaktivatoren und Farbmittel enthalten.

Erfindungsgemäß geeignete stabilisierende Säuren sind zum Beispiel Phosphor-, Citronen-, Benzoe-, m-Nitro-benzoe-, p-(p-Anilinophenylazo)-benzolsulfon-, 4,4'-Dinitro-2,2'-stilbendisulfon-, Itacon-, Wein-und p-Toluolsulfonsäure, sowie Gemische aus diesen Säuren. Phosphorsäure wird bevorzugt als stabilisierende Säure verwendet. Der Anteil der gegebenenfalls zugesetzten stabilisierenden Säure beträgt vorzugsweise etwa 0,3 bis 2,0 %, insbesondere etwa 0,75 bis 1,5 %.

Zu den geeigneten Belichtungsindikatoren zählen u. a. 4-Phenylazodiphenylamin, Eosin, Azobenzol, Calcozine, Fuchsin-Farbstoffe, Kristallviolett und Methylenblau. 4-Phenylazodiphenylamin wird bevorzugt. Der Anteil des gegebenenfalls zugesetzten Belichtungsindikators am Gemisch beträgt vorzugsweise etwa 0,001 bis 0,35 Gew.-%, insbesondere etwa 0,002 bis 0,3 Gew.-%, und ganz besonders bevorzugt etwa 0,005 bis 0,2 Gew.-%.

Der im Gemisch gegebenenfalls enthaltene Photoaktivator sollte eine Aminoverbindung sein, durch deren synergistisches Zusammenwirken mit dem radikalischen Photoinitiator die Halbwertzeit der Photoinitiatorradikale, die normalerweise bei etwa $10^{-9}$ bis $10^{-15}$ Sekunden liegt, ausgedehnt wird. Beispiele geeigneter Photoaktivatoren sind 4-Dimethylamino-benzoesäure-2-(n-butoxy)-ethylester, 2-(Dimethylamino)-aminobenzoat und acrylierte Amine. Ethyl-4-dimethylaminobenzoat wird bevorzugt. Der Anteil an Photoaktivator im erfindungsgemäßen Gemisch liegt bevorzugt bei 1 bis 4 Gew.-%.

Das erfindungsgemäße Gemisch kann ferner einen Weichmacher enthalten. Zu den geeigneten Weichmachern zählen zum Beispiel Tributylphthalat, Triarylphosphat und, bevorzugt, Dioctylphthalat, sowie deren substituierte Derivate. Der Anteil an Weichmacher im Gemisch liegt vorzugsweise bei etwa 0,5 bis 1,25 Gew.-%.

Zu den geeigneten Farbmitteln zählen u. a. Rhodamin, Calcozin, Viktoriablau, Methylviolett und Pigmente wie Anthrachinon und Phthalocyanin. Im allgemeinen liegt das Farbmittel in Form einer Pigmentdispersion vor, die ein oder mehrere Pigmente und/oder Farbstoffe enthält, die in einem geeigneten Lösemittel oder Löse mittelgemisch dispergiert wurden. Der Anteil des gegebenenfalls zugesetzten Farbmittels am erfindungsgemäßen Gemisch beträgt vorzugsweise etwa 1,5 bis 4,0 Gew.-%, insbesondere etwa 1,75 bis 3,0 Gew.-%, und ganz besonders bevorzugt etwa 2,0 bis 2,75 Gew.-%.

Zu den Trägermaterialien, die für die Beschichtung mit dem erfindungsgemäßen Gemisch zur Herstellung von Flachdruckplatten geeignet sind, zählen beispielsweise transparente Folien, z. B. aus Polyester, Aluminium und seine Legierungen, andere Metalle, Silicium und ähnliche aus dem Stand der Technik bekannte Stoffe. Aluminium wird bevorzugt als Trägermaterial eingesetzt. Der Träger wird gegebenenfalls zunächst mit Hilfe eines üblichen Verfahrens aufgerauht und/oder geätzt und/oder anodisiert und kann außerdem zusätzlich z. B. mit Polyvinylphosphonsäure, Natriumsilikat oder anderen hydrophilierend wirkenden Mitteln behandelt werden.

Zur Herstellung von Flachdruckplatten wird ein Schichtträger auf Basis von Aluminium zunächst vorzugsweise in bekannter Weise, z.B. durch Drahtbürsten, Naßschleifen oder auf elektrochemischem Weg, z. B. in einem Salzsäureelektrolyten, aufgerauht. Die aufgerauhte Platte wird danach vorzugsweise auf bekannte Weise anodisch oxydiert, z. B. in Schwefel-oder Phosphorsäure. Die aufgerauhte und gegebenenfalls anodisch oxydierte Oberfläche wird anschließend bevorzugt noch einer hydrophilierenden Nachbehandlung unterworfen, z. B. mit Polyvinylphosphonsäure, Natriumsilikat oder dergleichen. Die Nachbe handlung erfolgt ebenfalls in bekannter Weise. Die solchermaßen vorbereitete Platte wird mit dem erfindungsgemäßen Gemisch beschichtet und anschließend getrocknet. Das Schichtgewicht beträgt vorzugsweise etwa 0,6 bis 2,5 g/m², insbesondere etwa 0,8 bis 2,0 g/m², und ganz besonders bevorzugt etwa 1,2 bis 1,5 g/m²; es ist jedoch im Rahmen der vorliegenden Erfindung nicht von entscheidender Bedeutung.

Gegebenenfalls kann die Platte anschließend noch mit einer Deckschicht aus einer wäßrigen Lösung eines filmbildenden polymeren Harzes versehen und nochmals getrocknet werden. Das Gewicht dieser Schicht beträgt vorzugsweise 0,5 bis 6,0 g/m², insbesondere 0,75 bis 4,0 g/m², und ganz besonders bevorzugt 1,0 bis 2,5 g/m².

Zu den Polymeren, die für die Bildung einer Deckschicht geeignet sind, zählen beispielsweise Polyvinylalkohol, Polyvinylalkohol/Polyvinylacetat-Copolymere, Polyvinylpyrrolidon, Polyvinylpyrrolidon/Polyvinylacetat-Copolymere, Polyacrylsäure, Butadien-Maleinsäure-Copolymere und Polyvinylmethylether.

Bei der oben beschriebenen Kombination von Photoinitiator, Aminoacrylat und weiteren Monomeren ist häufig eine sauerstoffhemmende Deckschicht nicht erforderlich

Die so hergestellte Druckplatte wird bevorzugt durch eine negative Testvorlage mittels aktinischer Strahlung belichtet. Die belichtete Platte wird mit einem geeigneten wäßrigen Entwicklergemisch entwickelt, z. B. mit einem Entwickler, der eine oder mehrere der folgenden Verbindungen enthält:

a) ein Natrium-, Kalium-oder Lithiumsalz von Monooctyl-, -decyl-oder -dodecylsulfat,

b) ein Natrium-, Lithium-, Kalium-oder Ammoniummetasilikat,

c) ein Lithium-, Kalium-, Natrium-oder Ammoniumborat,

d) eine aliphatische Dicarbonsäure mit 2 bis 6 C-Atomen oder eines ihrer Natrium-, Kalium-oder Ammoniumsalze und

e) Mono-, Di-oder Trinatrium oder -kaliumphosphat.

Auch Entwickler mit einem Gehalt an Wasser und Benzoesäure oder Natrium-, Lithium-oder Kaliumbenzoaten oder deren Hydroxylgruppen tragenden Derivaten sowie die in der US-A 4 436 807 beschriebenen Entwickler sind geeignet.

Die entwickelte Platte wird üblicherweise noch mit einem Konservierungsmittel behandelt, das z. B. ein hydrophiles Polymeres, wie in kaltem Wasser lösliches Dextrin und/oder Polyvinylpyrrolidon; ein nichtionisches Netzmittel, ein Feuchtmittel, ein anorganisches Salz oder Wasser sein kann, wie aus der US-A 4 213 887 hervorgeht.

Es ist bekannt, daß die mit einer so hergestellten Platte erzielbare Druckauflage durch eine Wärmebehandlung der belichteten und entwickelten Druckplatte noch gesteigert werden kann. Dabei wird die Druckplatte zunächst mit einer Lösung behandelt, durch die eine Hydrophilieeinbuße der Bildhintergrundstellen beim Einbrennen verhindert wird. Eine hierfür geeignete Lösung wird beispielsweise in der US-A 4 355 096 beschrieben. Nach dieser vorbereitenden Behandlung wird die Platte bei einer Temperatur zwischen 180° C und der Verformungstemperatur des Trägers, bevorzugt bei etwa 240° C, behandelt. Die Dauer dieser Einbrennbehandlung ist umgekehrt proportional zur Temperatur und schwankt zwischen etwa 2 und 15 Minuten. Bei 240° C beträgt sie etwa 7 Minuten.

**Beispiel 1**

Eine 20 x 63 cm große Platte aus einer für Druckzwecke geeigneten Aluminiumlegierung des Typs 1100 wird mit einer wäßrig-alkalischen Entfettungslösung entfettet und in einem Medium aus Salpetersäure und Aluminiumnitrat mit Wechselstrom von 900 Coulomb elektrochemisch aufgerauht. Die aufgerauhte Platte wird gut abgespült und in einem Schwefelsäurebad anodisch oxydiert. Die Stromstärke und Spannung wird so gewählt, daß eine Oxidschicht von 2,8 g/m² erhalten wird. Danach wird die Platte nochmals abgespült und durch eine Tauchbehandlung in einer Polyvinylphosphonsäurelösung hydrophiliert. Nach einem letzten Spülgang wird die Platte getrocknet und anschließend mit einer Lösung der folgenden Zusammensetzung schleuderbeschichtet:

4,54 Gew.-% des unten beschriebenen Bindemittels,

4,02 Gew.-% Pentaerythrittetraacrylat,

0,32 Gew.-% 2-Stilbenyl-4,6-bis-(trichlormethyl)-triazin und

91,12 Gew.-% Ethylenglykolmonomethylether

Das Bindemittel wird wie folgt hergestellt:

Bei einer Temperatur von 70° C werden im Lauf von 16 Stunden 75 g Vinol 523 (ein Vinylalkohol/Vinylacetat-Copolymeres mit einem Anteil an Vinylalkoholeinheiten von etwa 75 bis 80 Gew.-% und einem durchschnittlichen Molekulargewicht von 70.000) in einer Lösung aus 225 g Wasser und 200 g Ethanol gelöst. Anschließend werden unter starkem Rühren 10,13 g Salzsäure -(37 %ig) hinzugefügt und die Temperatur auf 60° C eingestellt. 37,66 g Propionaldehyd werden langsam zu dem Reaktionsgemisch gegeben. Gleichzeitig erfolgt die langsame Zugabe von 250 g Ethanol. Anschließend wird das Gemisch durch Versetzen mit einem Natriumcarbonat/Natriumhydroxidgemisch (50:50) auf einen pH-Wert von 7,0 eingestellt. Das Reaktionsprodukt wird durch Ausfällen mit Wasser in Form eines Granulats isoliert. Es folgt eine Trocknung, in deren Verlauf der Feuchtigkeitsgehalt des Produkts auf maximal 1 % gesenkt wird. Die Ausbeute beträgt 107 g oder 96 %. Das durchschnittliche Molekulargewicht beträgt 90.000.

Das erhaltene Produkt wird mit Hilfe üblicher Analyseverfahren untersucht. Es ergibt sich folgende Zusammensetzung: 13,6 % Acetatgruppen, 9,8 % Hydroxylgruppen und 76,6 % Acetalgruppen. Von den Acetalgruppen sind 80 % Sechsringacetale, 4 % Fünfringacetale und 16 % intermolekulare Acetale.

Nach dem Trocknen wird auf die beschichtete Platte die folgende Lösung aufgeschleudert:

2 Gew.-% Polyvinylalkohol,

45 Gew.-% Ethanol und

53 Gew.-% Wasser

Die beschichtete und getrocknete Platte wird mittels aktinischer Strahlung durch eine Negativ-Testvorlage so belichtet, daß Stufe 7 eines 21-Stufen-Stauffer-Keils voll gedeckt ist. Die Platte wird mit einem Gemisch aus

6,9 Gew.-% Natriumbenzoat,

3,0 Gew.-% Natriumoctylsulfat,

2,8 Gew.-% Trinatriumphosphat,

1,5 Gew.-% Mononatriumphosphat und

85,8 Gew.-% Wasser,
dessen pH-Wert 7,3 beträgt, entwickelt und mit einem Gemisch aus

5,52 Gew.-% Dextrin (hydrolysiertes Tapiokadextrin),

1,61 Gew.-% Natriumoctylsulfat,

1,00 Gew.-% Triton X-100 - (Isooctylphenolpolyoxyethylenether; 4,5 mol Ethylenoxid),

0,05 Gew.-% 1,4-Dimethyl-6-acetoxydioxan,

2,37 Gew.-% $H_3PO_4$ und

89,45 Gew.-% Wasser
konserviert. Von der fertigen Druckplatte wird auf einer Solna-Bogenoffsetmaschine, die mit einem Dahlgren-Feuchtwerk ausgestattet ist, mit stark abreibender Druckfarbe und bei großer Belastung in der Maschine so lange gedruckt, bis die Platte unbrauchbar wird. Es werden 225.000 gute Drucke erhalten.

Beispiel 2

Eine nach den Angaben von Beispiel 1 ausgewählte und vorbehandelte Aluminiumplatte wird mit einer Lösung der folgenden Zusammensetzung schleuderbeschichtet:

4,54 Gew.-% des unten beschriebenen Bindemittels,

4,02 Gew.-% Dipentaerythritmonohydroxypentaacrylat,

0,32 Gew.-% 2-Stilbenyl-4,6-bis-(trichlormethyl)-triazin und

91,12 Gew.-% Ethylenglykolmonomethylether.
Das Bindemittel wird wie folgt hergestellt:
Bei einer Temperatur von 70° C werden im Lauf von 16 Stunden 40 g Gelvatol 20-60 (ein Vinylalkohol/Vinylacetat-Copolymeres mit einem Anteil an Vinylalkoholeinheiten von 75-80 Gew.-% und einem durchschnittlichen Molekulargewicht von 60.000) in einer Lösung aus 120 g Wasser und 120 g Ethanol gelöst. Anschließend werden unter starkem Rühren 10,13 g Salzsäure (37 %ig) und 27,41 g Hexanal hinzugefügt; dabei wird die Temperatur auf 60° C eingestellt.

Das erhaltene Produkt wird mit Hilfe üblicher Analyseverfahren untersucht. Es ergibt sich folgende Zusammensetzung: 15,2 % Acetatgruppen, 7,6 % Hydroxylgruppen und 77,2 % Acetalgruppen. Von den Acetalgruppen sind 80% Sechsringacetale, 4 % Fünfringacetale und 16 % intermolekulare Acetale.

Anschließend wird die Platte getrocknet. Auf die getrocknete Platte wird eine nach den Angaben von Beispiel 1 hergestellte Polyvinylalkohollösung aufgeschleudert.

Die beschichtete und getrocknete Platte wird nach den Angaben von Beispiel 1 belichtet, entwickelt und konserviert.

Im Druckversuch unter den in Beispiel 1 angegebenen Bedingungen liefert die Platte 240.000 gute Drucke.

Beispiel 3

Eine nach den Angaben von Beispiel 1 ausgewählte und vorbehandelte Aluminiumplatte wird mit einer Lösung der folgenden Zusammensetzung schleuderbeschichtet:

4,54 Gew.-% des unten beschriebenen Bindemittels,

4,02 Gew.-% Pentaerythritacrylat,

0,32 Gew.-% 2-Stilbenyl-4,6-bis-(trichlormethyl)-triazin und

91,12 Gew.-% Ethylenglykolmonomethylether
Das verwendete Bindemittel wird wie folgt hergestellt:
Bei einer Temperatur von 70° C werden im Lauf von 16 Stunden 75 g Elvanol 52-22 (ein Vinylalkohol/Vinylacetat-Copolymeres mit einem Anteil an Vinylalkoholeinheiten von 75-80 Gew.-% und einem durchschnittlichen Molekulargewicht von 90.000) in einer Lösung aus 225 g Wasser und 200 g Ethanol gelöst. Anschließend werden unter starkem Rühren 10,13g Salzsäure (37 %ig) und 28,62 g Acetaldehyd hinzugefügt; dabei wird die Temperatur auf 60° C eingestellt.

Das erhaltene Produkt wird mit Hilfe üblicher Analyseverfahren untersucht. Es ergibt sich folgende Zusammen-setzung: 17,2 % Acetatgruppen, 13,6 % Hydroxylgruppen und 69,2 % Acetalgruppen. Von den Acetalgruppen sind 80% Sechsringacetale, 4 % Fünfringacetale und 16 % intermolekulare Acetale.

Anschließend wird die Platte getrocknet. Auf die getrocknete Platte wird eine nach den Angaben von Beispiel 1 hergestellte Polyvinylalkohollösung aufgeschleudert.

Die beschichtete und getrocknete Platte wird nach den Angaben von Beispiel 1 belichtet, entwickelt und konserviert.

Im Druckversuch unter den in Beispiel 1 angegebenen Bedingungen liefert die Platte 240.000 gute Drucke.

Beispiel 4

Eine nach den Angaben von Beispiel 1 vorbehandelte Aluminiumplatte wird mit einer Lösung der folgenden Zusammensetzung schleuderbeschichtet:

27,6 g der unten beschriebenen Harzlösung (Feststoffanteil 4,42 g) werden mit 14,5 g der folgenden Stammlösung versetzt:

17,2 g Polyethylenglykol-200-diacrylat,

17,2 g Celrad 7100,

10,3 g Trimethylolpropantriacrylat,

10,3 g Purelast 155A,

0,2 g 2-Isopropyl-9H-thioxanthen-9-on und

43,1 g Ethanol.

Die Harzlösung wird wie folgt erhalten:

Bei einer Temperatur von 70° C werden im Lauf von 14 Stunden 40 g Vinol 523 in einer Lösung aus 150 g Wasser und 120 g n-Propanol gelöst. Anschließend wird die Temperatur auf 60° C eingestellt, und unter starkem Rühren werden 1,5 g Salzsäure (37 %ig) hinzugefügt, und 11,8 g Acetaldehyd werden langsam zu dem Reaktionsgemisch gegeben, das noch 6 Stunden nachgerührt wird.

Die beschichtete und getrocknete Platte wird mittels aktinischer Strahlung durch eine Negativ-Testvorlage so belichtet, daß auf einem 21-Stufen-Stauffer-Keil eine vollgedeckte Stufe 7 erhalten wird.

Die Platte läßt sich mit Leitungswasser vollständig entwickeln und desensibilisieren. Anschließend wird mit dem in Beispiel 1 beschriebenen Gemisch konserviert. Im Druckversuch unter den Bedingungen von Beispiel 1 ergibt die Platte 280.000 gute Drucke.

Beispiel 5

Eine nach den Angaben von Beispiel 1 vorbehandelte Aluminiumplatte wird mit einer Lösung der folgenden Zusammensetzung schleuderbeschichtet:

Bei einer Temperatur von 70° C werden im Lauf von 14 Stunden 40 g Vinol 523 in einem Gemisch aus 135 g Wasser und 135 g n-Propanol gelöst. Dann wird die Temperatur auf 60° C eingestellt, und 1,5 g Salzsäure werden eingerührt. Anschließend werden 11,8 g Acetaldehyd zugegeben, und es wird weitere sechs Stunden kräftig weitergerührt. Ein Teil der so erhaltenen Harzlösung wird über Nacht (ca. 16 Std.) im Abzug zu einem dünnen Film getrocknet; anschließend wird der Trocknungsvorgang in einem Vakuumtrockenschrank bei 55° C beendet.

5 g des erhaltenen Films (etwa 80 % Feststoffgehalt) werden in einem Gemisch aus 11 g Wasser und 11 g n-Propanol gelöst. Die erhaltene Lösung wird mit einer Stammlösung der folgenden Zusammensetzung versetzt:

17,2 g Polyethylenglykol-200-diacrylat,

17,2 g Celrad 7100,

10,3 g Trimethylolpropanpolyethylenoxytriacrylat,

10,3 g Purelast 155A,

1,7 g 2-Isopropyl-9H-thioxanthen-9-on und

43,1 g Ethanol.

Die beschichtete und getrocknete Platte wird nach den Angaben von Beispiel 1 belichtet, entwickelt und konserviert.

Im Druckversuch unter den im Beispiel 1 angegebenen Bedingungen liefert die Platte 305.000 gute Drucke.

Beispiel 6

Eine nach den Angaben von Beispiel 1 vorbehandelte Aluminiumplatte wird mit einer Lösung der im folgenden angegebenen Zusammensetzung schleuderbeschichtet:

Bei einer Temperatur von 70° C werden im Lauf von 16 Stunden 80 g Gelvatol 20-30 (ein Vinylalkohol/Vinylacetat-Copolymeres mit einem Anteil an Vinylalkoholeinheiten von etwa 75 bis 80 Gew.-% und einem durchschnittlichen Molekulargewicht von 10.000) in einer Lösung aus 200 g Wasser und 160 g n-Propanol gelöst. Die Temperatur wird 16 Stunden auf 70° C gehalten und dann auf 60° C eingestellt. Unter starkem Rühren werden 1,5 g Salzsäure (37 %ig) hinzugefügt, und 24,3 g Acetaldehyd werden innerhalb von 5 Stunden zu dem Reaktionsgemisch gegeben. Ein Teil der Harzlösung wird wie in Beispiel 5 getrocknet.

4,5 g des erhaltenen Polymeren (etwa 4 g Feststoffgehalt) werden in einem Gemisch aus 11 g Wasser und 11 g n-Propanol gelöst. Die erhaltene Lösung wird mit 14,5 g einer Stammlösung der folgenden Zusammensetzung versetzt:

27,6 g Polyethylenglykol-200-diacrylat,

27,6 g Celrad 7100,

1,7 g 2-Isopropyl-9H-thioxanthen-9-on und

43,1 g Ethanol.

Die beschichtete und getrocknete Platte wird nach den Angaben von Beispiel 1 belichtet, entwickelt und konserviert.

Im Druckversuch unter den im Beispiel 1 angegebenen Bedingungen liefert die Platte 295.000 gute Drucke.

Beispiel 7

Ein entfettetes, gefärbtes einfädiges Polyestersieb (lichte Maschenweite 0,05 mm) wird mit der in Beispiel 4 beschriebenen Lösung beschichtet und anschließend getrocknet. Das Sieb wird mittels einer 5 kW Quecksilberhochdrucklampe durch eine Photomaske mit UV-Licht von 24 mJ/cm² belichtet und anschließend mit Wasser entwickelt. Die erhaltene Siebdruckschablone zeichnet sich im Druckversuch durch hohe Bildauflösung (bis zu Linienbreiten von 100 bis 150µm) und Abriebfestigkeit aus.

Beispiel 8

Bei einer Temperatur von 70° C werden im Lauf von 16 Stunden 40,0 g Gelvatol 20-30 (ein Vinylalkohol/Vinylacetat-Copolymeres mit einem Anteil an Vinylalkoholeinheiten von etwa 75 bis 80 Gew.-% und einem durchschnittlichen Molekulargewicht von 10.000) in einer Lösung aus 100 g Wasser und 80 g Ethanol gelöst. Anschließend werden unter starkem Rühren 1,5 g Salzsäure (37 %ig) hinzugefügt und die Temperatur auf 60° C eingestellt. 12,2 g Acetaldehyd werden langsam zu dem Reaktionsgemisch gegeben, und es wird weitere 6 Stunden gerührt.

19,6 g der erhaltenen Harzlösung - (Feststoffgehalt 4,37 g) werden mit 14,5 g der Stammlösung von Beispiel 4 versetzt, wobei eine klare Lösung entsteht. Mit dieser Lösung wird ein entfettetes, eingefärbtes Polyestersieb mit 0,05 mm lichter Maschenweite beschichtet und anschließend getrocknet. Das beschichtete Sieb wird wie in Beispiel 7 belichtet und entwickelt. Die erhaltene Siebdruckschablone zeichnet sich durch eine gute Bildauflösung aus (bis zu Linienbreiten von 100-150µm).

Beispiel 9 (Vergleichsbeispiel)

Zum Vergleich werden bei einer Temperatur von 70° C im Lauf von 16 Stunden 40 g eines Vinylalkohol/Vinylacetat-Copolymeren mit einem Anteil an Vinylalkoholeinheiten von 75-80 Gew.-% und einem durchschnittlichen Molekulargewicht von 70.000 in einer Lösung aus 100 g Wasser und 160 g n-Propanol gelöst. Anschließend werden unter starkem Rühren während 5 Stunden 1,5 g Salzsäure und 15,4 g Propionaldehyd hinzugefügt; dabei wird die Temperatur auf 60° C eingestellt. Dann werden weitere 50 g Wasser und 80 g n-Propanol zugesetzt.

35,1 Gt der erhaltenen Harzlösung - (Feststoffgehalt 6,1 g) werden mit 14,5 g der Stammlösung von Beispiel 4 versetzt. Mit der resultierenden klaren Lösung wird ein entfettetes, eingefärbtes Polyestersieb mit 0,05 mm lichter Maschenweite beschichtet und anschließend getrocknet. Das beschichtete Sieb wird wie in Beispiel 7 belichtet. Es kann jedoch nicht mit Wasser entwickelt werden.

Beispiel 10 (Vergleichsbeispiel)

Zum Vergleich werden bei einer Temperatur von 70° C im Lauf von 14 Stunden 40 g eines Vinylalkohol/Vinylacetat-Copolymeren mit einem Anteil an Vinylalkoholeinheiten von 75-80 Gew.-% und einem durchschnittlichen Molekulargewicht von 26.000 in einer Lösung aus 150 g Wasser und 120 g n-Propanol gelöst. Anschließend werden unter starkem Rühren während 6 Stunden 1,5 g Salzsäure und 11,8 g Formaldehyd hinzugefügt; dabei wird die Temperatur auf 60° C eingestellt.

21,2 g der erhaltenen Harzlösung - (Feststoffgehalt 4,42g) werden mit 14,5 g der Stammlösung von Beispiel 4 versetzt, wobei ein unbrauchbares Gel erhalten wird.

Beispiel 11 (Vergleichsbeispiel)

Zum Vergleich werden bei einer Temperatur von 70° C im Lauf von 14 Stunden 40 g eines Vinylalkohol/Vinylacetat-Copolymeren mit einem Anteil an Vinylalkoholeinheiten von 75-80 Gew.-% und einem durchschnittlichen Molekulargewicht von 10.000 in einer Lösung aus 150 g Wasser und 120 g n-Propanol gelöst. Anschließend werden unter starkem Rühren während 5 Stunden 1,5 g Salzsäure und 11,8 g Caprylaldehyd hinzugefügt; dabei wird die Temperatur auf 60° C eingestellt.

16,4 g der erhaltenen Harzlösung - (Feststoffgehalt 4,42 g) werden mit 20,75 g einer Stammlösung aus

19,3 g Polyethylenglykol-200-diacrylat,

19,3 g Celrad 7100,

1,2 g 2-Isopropyl-9H-thioxanthen-9-on und

52,4 g Ethanol
versetzt, wobei eine klare Lösung entsteht.

Mit dieser Lösung wird ein entfettetes, eingefärbtes Polyestersieb mit 0,05 mm lichter Maschenweite beschichtet und getrocknet. Das beschichtete Sieb wird nach den Angaben von Beispiel 7 belichtet. Es läßt sich mit Wasser jedoch nicht entwickeln.

Beispiel 12 (Vergleichsbeispiel)

Zum Vergleich werden 20 g der Harzlösung aus Beispiel 8 (4,37 g Feststoffgehalt) mit 14,5 g der folgenden Stammlösung versetzt:

17,5 g Polyethylenglykol-200-diacrylat,

17,5 g Celrad 7100,

10,5 g Trimethylolpropantriacrylat,

10,5 g Purelast 155A,

1,76 g Benzophenon und

43,9 g Ethanol.

Mit der erhaltenen Lösung wird ein entfettetes, eingefärbtes Polyestersieb mit 0,05 mm lichter Maschenweite beschichtet und getrocknet. Anschließend wird wie in Beispiel 7 belichtet. Beim Entwickeln mit Wasser erhält man kein sichtbares Bild; schließlich werden sowohl die belichteten, als auch die unbelichteten Stellen ausgewaschen.

Beispiel 13

Mit der in Beispiel 5 beschriebenen Beschichtungslösung wird ein entfettetes, eingefärbtes Polyestersieb mit 0,05 mm lichter Maschenweite beschichtet und getrocknet. Die Belichtung erfolgt in einem NuArc Flip-top-Gerät, das mit einem weichen Gummituch für die Vakuumbelichtung von Sieben ausgerüstet ist. Das Sieb wird mittels eines auf 100 Belichtungseinheiten eingestellten Autotypie-Belichtungsautomaten belichtet, mit dem die Belichtung eines Siebs mit dem 1-, 0,7-, 0,5-0,33-und 0,25-fachen der vollen Belichtungsenergie erfolgen kann. Das belichtete Sieb wird mit Wasser entwickelt, wobei eine Siebdruckschablone mit guter Auflösung (bis zu Linienbreiten von 100-150μm) erhalten wird. Bezogen auf den verwendeten Belichtungsautomaten wird eine optimale Belichtungsenergie von weniger als 25 Einheiten benötigt.

Beispiel 14 (Vergleichsbeispiel)

Zum Vergleich werden 20 g der Polymerlösung von Beispiel8 (Feststoffgehalt 4,37 g) mit 14,5 g der folgenden Stammlösung versetzt:

24,8 g Polyethylenglykol-200-diacrylat,

15,2 g Trimethylolpropantriacrylat,

15,2 g Purelast 155 A,

1,7 g 2-Isopropyl-9H-thioxanthen-9-on und

43,1 g Ethanol.

Mit dieser Lösung wird ein entfettetes, eingefärbtes Polyestersieb mit 0,05 mm lichter Maschenweite beschichtet und anschließend getrocknet. Darauf wird wie in Beispiel 7 entwickelt. Beim Entwickeln mit Wasser entsteht ein sehr - schwaches Bild; schließlich werden sowohl die belichteten als auch die unbelichteten Stellen ausgewaschen. Hieraus wird die Notwendigkeit der Zugabe eines oligomeren Aminodiacrylats ersichtlich.

Beispiel 15

Nach den Angaben von Beispiel 6 wird eine Polyvinylacetallösung hergestellt. Ein Teil der Lösung wird nach den Angaben von Beispiel 4 zu einem dünnen Film getrocknet.

4,5 g des erhaltenen Polymeren - (Feststoffgehalt 4 g) werden in einem Gemisch aus 11 g Wasser und 11 g n-Propanol gelöst und mit 14,5 g der Stammlösung von Beispiel 6 versetzt.

Es wird eine klare Lösung erhalten, mit der ein entfettetes, eingefärbtes Polyestersieb mit 0,05 mm lichter Maschenweite beschichtet und anschließend getrocknet wird. Das Sieb wird in einem NuArc Flip-top-Gerät mittels eines Autotypie-Belichtungsautomaten belichtet und mit Wasser entwickelt, wobei die unbelichteten Stellen entfernt werden und eine Siebdruckschablone mit guter Bildauflösung (bis zu Linienbreiten von 100-150µm) erhalten wird.

Beispiel 16

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 1 beschriebenen Bindemittels,

2,01 Gew.-% Dipentaerythritmonohydroxypentaacrylat,

2,01 Gew.-% des unten angegebenen diacrylierten Urethanoligomeren,

0,32 Gew.-% 2-Stilbenyl-4,6-bis-(trichlormethyl)-triazin und

91,12 Gew.-% Ethylenglykolmonomethylether.

Das diacrylierte Urethanoligomere wird erhalten durch Umsetzen von 1,6-Hexandiol und Adipinsäure zu einem Polyester, wobei das Molverhältnis größer als 1:1 ist, und anschließendes Umsetzen des Polyesters mit Dicyclohexylmethan-4,4'diisocyanat, wobei das Molverhältnis von Diisocyanat zu Polyester 2:1 beträgt. Das entstandene Produkt wird mit 2-Hydroxyethylacrylat umgesetzt, wobei das Molverhältnis von Acrylat zu Diisocyanat-Polyester-Produkt 2:1 beträgt.

Die beschichtete und getrocknete Platte wird wie in Beispiel 1 mit Polyvinylalkohol beschichtet und erneut getrocknet. Sie wird dann wie in Beispiel 1 belichtet, entwickelt und konserviert. Unter den Bedingungen von Beispiel 1 ergibt die Platte 475.000 gute Drucke.

Beispiel 17

Eine Flachdruckplatte wird nach den Angaben von Beispiel 16 hergestellt und verarbeitet mit der Ausnahme, daß das diacrylierte Urethanoligomere weggelassen wird. Die so hergestellte Platte liefert 245.000 gute Drucke.

Beispiel 18

Eine Flachdruckplatte wird nach den Angaben von Beispiel 16 hergestellt und verarbeitet mit der Ausnahme, daß das Dipentaerythritmonohydroxypentaacrylat weggelassen wird. Die so hergestellte Platte liefert 260.000 gute Drucke.

Beispiel 19

Eine Flachdruckplatte wird nach den Angaben von Beispiel 16 hergestellt und verarbeitet mit der Ausnahme, daß die Polyvinylalkohol-Deckschicht weggelassen wird. Die so hergestellte Platte ergibt kine brauchbare Druckform, d. h. es können damit keine Bilder gedruckt werden.

Beispiel 20

Eine Flachdruckplatte wird nach den Angaben von Beispiel 16 hergestellt und verarbeitet mit der Ausnahme, daß das 2-Stilbenyl-4,6-bis-(trichlormethyl)-triazin weggelassen wird. Die so hergestellte Platte liefert kein brauchbares Druckergebnis.

Beispiel 21

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 3 beschriebenen Bindemittels,

2,01 Gew.-% Pentaerythrittetraacrylat,

2,01 Gew.-% des diacrylierten Urethanoligomeren aus Beispiel 16,

0,32 Gew.-% 2-Stilbenyl-4,6-bis-(trichlormethyl)-triazin und

91,12 Gew.-% Ethylenglykolmonomethylether

Die beschichtete und getrocknete Platte wird mit der Polyvinylalkohollösung von Beispiel 1 beschichtet und erneut getrocknet. Sie wird dann wie in Beispiel 1 entwickelt und konserviert. Unter den Bedingungen von Beispiel 1 werden 490.000 gute Drucke erhalten.

Beispiel 22

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 2 beschriebenen Bindemittels,

2,01 Gew.-% Pentaerythrittetraacrylat,

2,01 Gew.-% des diacrylierten Urethanoligomeren aus Beispiel 16,

0,32 Gew.-% 2-Stilbenyl-4,6-bis-(trichlormethyl)-triazin und

91,12 Gew.-% Ethylenglykolmonomethylether.

Die beschichtete und getrocknete Platte wird wie in Beispiel 1 mit Polyvinylalkohol beschichtet und erneut getrocknet. Sie wird dann wie in Beispiel 1 belichtet, entwickelt und konserviert.

Unter den Bedingungen von Beispiel 1 ergibt die Platte 450.000 gute Drucke.

Beispiel 23 (Vergleichsbeispiel)

Eine nach den Angaben von Beispiel 1 ausgewählte und vorbehandelte Aluminiumplatte wird mit einer Lösung der folgenden Zusammensetzung schleuderbeschichtet:

4,54 Gew.-% des Bindemittels Formvar 12/85

2,01 Gew.-% Pentaerythrittetraacrylat,

2,01 Gew.-% des diacrylierten Urethanoligomeren aus Beispiel 16,

0,32 Gew.-% 2-Stilbenyl-4,6-bis-(trichlormethyl)-triazin und

91,12 Gew.-% Ethylenglykolmonomethylether

Formvar 12/85 ist ein Polyvinylformal, Hersteller Monsanto Corp., St. Louis, Missouri, USA, hergestellt nach US-A 2 179 051. Eine Probe davon wird mit Hilfe üblicher Analyseverfahren untersucht, die zu folgendem Ergebnis führen: Das Produkt hat ein durchschnittliches Molekulargewicht von 32.000 und besteht zu 23,5 % aus Acetatgruppen, zu 5,7 % aus Hydroxylgruppen und zu 70,8 % aus Acetalgruppen. Von den Acetalgruppen sind 90 bis 95 % Sechsringacetale, 0 % Fünfringacetale und 5-10 % intermolekulare Acetale.

Die beschichtete und getrocknete Platte wird wie in Beispiel 1 mit Polyvinylalkohol beschichtet und erneut getrocknet. Sie wird dann wie in Beispiel 1 belichtet; anschließend wird versucht, sie nach den Angaben von Beispiel 1 zu entwickeln. Dabei stellt sich heraus, daß sich die Platte nicht entwickeln läßt. Keinerlei Anzeichen von Entschichtung oder Desensibilisierung können festgestellt werden.

Beispiel 24

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 1 beschriebenen Bindemittels,

2,85 Gew.-% Pentaerythrittetraacrylat,

0,86 Gew.-% Pentaerythrittriacrylat,

0,19 Gew.-% Pentaerythritdiacrylat,

0,12 Gew.-% Pentaerythritacrylat,

0,32 Gew.-% 2-Stilbenyl-4,6-bis-(trichlormethyl)-triazin,

Rest Ethylenglykolmonomethylether.

Die beschichtete und getrocknete Platte wird wie in Beispiel 1 mit Polyvinylalkohol beschichtet und erneut getrocknet. Sie wird dann wie in Beispiel 1 belichtet, entwickelt und konserviert. Unter den Bedingungen von Beispiel 1 ergibt die Platte 460.000 gute Drucke.

Beispiel 25

Eine Flachdruckplatte wird nach den Angaben von Beispiel 24 hergestellt und verarbeitet mit der Ausnahme, daß das Pentaerythritacrylat weggelassen wird. Die so hergestellte Platte liefert 195.000 gute Drucke.

Beispiel 26

Eine Flachdruckplatte wird nach den Angaben von Beispiel 24 hergestellt und verarbeitet mit der Ausnahme, daß das 2-Stilbenyl-4,6-bis-(trichlormethyl)triazin weggelassen wird. Die so hergestellte Platte liefert kein brauchbares Druckergebnis.

Beispiel 27

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 2 beschriebenen Bindemittels,

2,85 Gew.-% Pentaerythrittetraacrylat,

0,86 Gew.-% Pentaerythrittriacrylat,

0,19 Gew.-% Pentaerythritdiacrylat,

0,12 Gew.-% Pentaerythritacrylat,

0,32 Gew.-% 2-Stilbenyl-4,6-bis-(trichlormethyl)-triazin,

Rest Ethylenglykolmonomethylether.

Die beschichtete und getrocknete Platte wird wie in Beispiel 1 mit einer Polyvinylalkoholschicht überzogen. Sie wird dann wie in Beispiel 1 belichtet, entwickelt und konserviert. Unter den Bedingungen von Beispiel 1 ergibt die Platte 465.000 gute Drucke.

Beispiel 28

Eine nach den Angaben von Beispiel 1 ausgewählte und vorbehandelte Aluminiumplatte wird mit einer Lösung der folgenden Zusammensetzung schleuderbeschichtet:

4,54 Gew.-% des in Beispiel 3 beschriebenen Bindemittels,

2,85 Gew.-% Pentaerythrittetraacrylat,

0,86 Gew.-% Pentaerythrittriacrylat,

0,19 Gew.-% Pentaerythritdiacrylat,

0,12 Gew.-% Pentaerythritacrylat,

0,32 Gew.-% 2-Stilbenyl-4,6-bis-(trichlormethyl)-triazin,

Rest Ethylenglykolmonomethylether

Die beschichtete und getrocknete Platte wird wie in Beispiel 1 mit Polyvinylalkohol beschichtet und erneut getrocknet. Sie wird dann wie in Beispiel 1 belichtet, entwickelt und konserviert. Unter den Bedingungen von Beispiel 1 werden 470.000 gute Drucke erhalten.

**Claims**

1. Photopolymerisierbares Gemisch, das als wesentliche Bestandteile einen Photoinitiator, ein polymerisierbares Acryl-oder Methacrylsäurederivat mit einer oder mehreren ungesättigten Gruppen und ein polymeres Bindemittel aus Einheiten der allgemeinen Typen A, B und C enthält, wobei A in einem Mengenanteil von 5 bis 20 Gew.-% vorliegt und der Formel

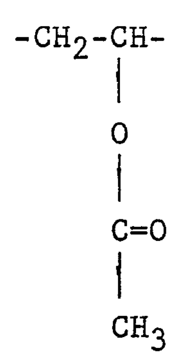

entspricht, B in einem Mengenanteil von 4 bis 30 Gew.-% vorliegt und der Formel

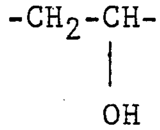

entspricht und C in einem Mengenanteil von 50 bis 91 Gew.-% vorliegt, dadurch gekennzeichnet, daß die Einheiten C aus Einheiten der Formel C I, C II und C III

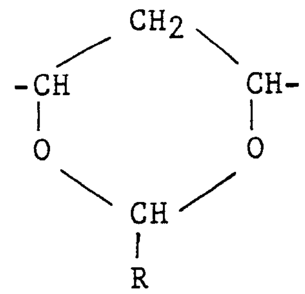

(C I),

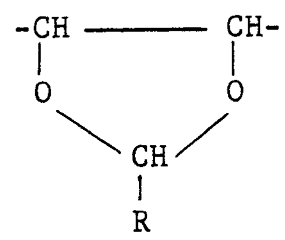

(C II),

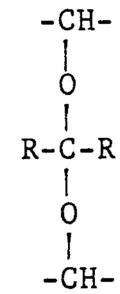

(C III)

bestehen, worin

R ein Wasserstoffatom oder eine niedere Alkylgruppe ist

und worin die Einheiten C I in einem Anteil von 75 bis 85 Gew.-%, die Einheiten C II in einem Anteil von 3 bis 5 Gew.-% und die Einheiten C III in einem Anteil von 10 bis 22 Gew.-%, bezogen auf das Gesamtgewicht der Einheiten C, vorliegen.

2. Photopolymerisierbares Gemisch nach Anspruch 1, dadurch gekennzeichnet, daß das polymere Bindemittel ein Molekulargewicht von 5.000 bis 100.000 hat.

3. Photopolymerisierbares Gemisch nach Anspruch 1, dadurch gekennzeichnet, daß das Acryl-oder Methacrylsäurederivat eine Verbindung mit 2 bis 6 Acryl-oder Methacrylsäureestergruppen ist.

4. Photopolymerisierbares Gemisch nach Anspruch 1, dadurch gekennzeichnet, daß es das Acryl-oder Methacrylsäurederivat in einem Mengenanteil von 20 bis 70 Gew.-%, bezogen auf seine nichtflüchtigen Bestandteile enthält.

5. Photopolymerisierbares Gemisch nach Anspruch 1, dadurch gekennzeichnet, daß das Acryl-oder Methacrylsäurederivat ein Gemisch aus

a) einem Acryl-oder Methacrylsäureester mit zwei oder mehreren ungesättigten Gruppen und

b) einem Oligomeren ist, das durch Umsetzen von 1 mol einer linearen polymeren Verbindung mit einem aktiven Wasserstoffatom an jedem Ende mit mindestens 2 mol eines Diisocyanats und Umsetzen des Reaktionsprodukts mit mindestens 2 mol einer ethylenisch ungesättigten Verbindung, die ein aktives Wasserstoffatom enthält, hergestellt worden ist.

6. Photopolymerisierbares Gemisch nach Anspruch 5, dadurch gekennzeichnet, daß das Oligomere in einem Anteil von 10 bis 35 Gew.-%, bezogen auf die Gesamtmenge an polymerisierbaren Verbindungen, darin enthalten ist.

7. Photopolymerisierbares Gemisch nach Anspruch 1, dadurch gekennzeichnet, daß das Acryl-oder Methacrylsäurederivat ein Gemisch aus einem Acryl-oder Methacrylsäureester mit mindestens zwei ungesättigten Gruppen und einem Acryl-oder Methacrylsäureester mit einer ungesättigten Gruppe ist.

8. Photopolymerisierbares Gemisch nach Anspruch 7, dadurch gekennzeichnet, daß der Acryl-oder Methacrylsäureester mit mindestens zwei ungesättigten Gruppen in einem Mengenanteil von mehr als 50 Gew.-%, bezogen auf die Gesamtmenge an polymerisierbaren Verbindungen, darin enthalten ist.

9. Photopolymerisierbares Aufzeichnungsmaterial mit einem Schichtträger und einer photopolymerisierbaren Schicht, die aus einem Gemisch gemäß einem der Ansprüche 1 bis 8 besteht.

10. Photopolymerisierbares Aufzeichnungsmaterial nach Anspruch 9, dadurch gekennzeichnet, daß der Schichtträger ein Siebdruckschablonenträger ist.